Europäisches Patentamt

European Patent Office

Office européen des brevets

(11) Veröffentlichungsnummer: **0 339 554**

**A2**

## (12) EUROPÄISCHE PATENTANMELDUNG

(21) Anmeldenummer: 89107403.1

(22) Anmeldetag: 24.04.89

(51) Int. Cl.⁴: **H01J 27/16 , H01J 37/08**

(30) Priorität: 26.04.88 DE 3814053

(43) Veröffentlichungstag der Anmeldung:
02.11.89 Patentblatt 89/44

(84) Benannte Vertragsstaaten:
AT BE CH DE ES FR GB IT LI LU NL SE

(71) Anmelder: HAUZER HOLDING B.V.
Groethofstraat 27
NL-5900 AE Venlo(NL)

(72) Erfinder: Löb, Horst, Dr. Prof.
Heinrich-Buff-Ring 16
D-6300 Giessen(DE)

(74) Vertreter: Dipl.-Phys.Dr. Manitz Dipl.-Ing.,
Dipl.-W.-Ing. Finsterwald Dipl.-Ing. Grämkow
Dipl.-Chem.Dr. Heyn Dipl.-Phys. Rotermund
Morgan, B.Sc.(Phys.) Robert-Koch-Strasse 1
D-8000 München 22(DE)

(54) **Hochfrequenz-Ionenstrahlquelle.**

(57) Es wird eine monoenergetische Ionenquelle für die Erzeugung eines Ionenstrahles beschrieben, wobei die Ionenenergien, die unterhalb von 100 eV und auch oberhalb von 5 keV liegen, im ganzen Bereich der dazwischen liegenden Energien und bei allen vorkommenden Ionenstromdichten unabhängig voneinander frei wählbar mit Hilfe der Betriebsparameter der Quelle eingestellt werden können. Die Ionenstromdichte ist dabei unabhängig von der Ionenenergie frei einstellbar. Die Ionenquelle ist mit einer ionenoptischen Strahlfokussierung versehen, und die Strahlquelle kann insbesondere auch zur Herstellung von Metallionen verwendet werden.

Fig. 1

EP 0 339 554 A2

# Hochfrequenz-Ionenstrahlquelle

Die Erfindung betrifft eine Hochfrequenz-Ionenstrahlquelle, bestehend aus einem mit dem jeweils zu ionisierenden Arbeitsgas, insbesondere gasförmigen, kondensierbaren, metallischen Dämpfen und Metallverbindungen beschickbaren Ionisatorgefäß, einer mit einer Hochfrequenzquelle verbundenen Spule zur Erzeugung eines durch induktiv angeregte Entladung entstehenden Plasmas im Ionisatorgefäß, sowie einem Strahlbildungs-system mit mehreren Extraktionsgittern.

Die Technik der Oberflächenbearbeitung und insbesondere die Herstellung dünner Schichten hat während der vergangenen Jahre auch in ihrer industriellen Anwendung große Bedeutung erlangt. Es gibt heute zahlreiche Verfahren zur Herstellung oder Bearbeitung von dünnen Schichten bzw. zur Behandlung von Materialoberflächen. Sie alle erfordern entweder verminderten Druck oder Vakuum im bearbeitungsraum und werden daher in Vakuumanlagen durchgeführt.

Einige sehr bekannte Verfahren beruhen auf durch Joule'sche Wärme erzeugter Verdampfung in Öfen, Schiffchen, Tiegeln usw., entweder durch Stromwärme oder durch Elektronen- oder Ionenbeschuß. Andere Verfahren benutzen die Verdampfung mittels eines anodischen oder kathodischen Lichtbogens oder auch die Wirbelstromerhitzung von leitendem Material in einem induzierten Wechselstromfeld. Zu erwähnen ist auch die großflächige Sublimation auf Kathoden in den verschiedenen Ausführungsformen der Kathodenzerstäubung mit und ohne magnetische Verstärkung der Ionisation in der Gleichstrom-oder Wechselstromglimmentladung.

Die bekannten und gebräuchlichen Verdampfungsquellen liefern für die Kondensation auf dem Substrat Atome und Ionen mit einer solchen Verteilung der kinetischen Energien oder Teilchen, daß die hochenergetischen Teile mehr Zerstörung in der Art von Kristallzerspaltung, Kristallzerstörung oder der Kathodenzerstäubung ähnlichem Zerfall einer Oberfläche bewirken als gute, gleichmäßige Kondensation, die fehlerfreies Kristallwachstum ergibt. Andererseits erreichen die auftreffenden Teilchen niedriger Energie oft kaum die notwendige Bewegungsenergie an der Oberfläche zum ordnungsgemäßen Einbau in ein Kristallgitter.

Oft reichen diese Energien nicht aus, um bei einer Beschichtung eine Haftfestigkeit in der Grenzfläche zwischen dem Substrat und der Schicht zu erhalten. Manchmal wird eine hohe Energie der Teilchen im Beschichtungsstrahl benötigt, um die Oberflächenenergie des Substrates zu erhöhen, wenn die Substrattemperatur aus gewissen Gründen niedrig gehalten werden muß, oder der Wärmeaustausch zwischen Substrat und der obersten Kondensationsebene mangelhaft ist.

Es sind auch bereits Hochfrequenz-Ionenstrahlquellen der eingangs angegebenen Art bekannt (vgl. EP-A2 0 261 338 und DE-A1 37 08 716) bei denen die HF-Spule außerhalb des jeweiligen Ionisatorgefäßes angeordnet ist und speziell ausgebildete Ionenextraktionssysteme verwendet sind. Derartige Ionenstrahlquellen ermöglichen die Erzeugung nur einfach geladener Ionen, d.h. nur eines einzigen, monoenergetischen Strahlpeaks, sind auch für reaktive Gase verwendbar, besitzen einen robusten und einfachen Aufbau sowie eine einfache Versorgungs-Regeleinheit und sind geeignet, die praktischen Anforderungen an Betriebssicherheit und Lebensdauer zur erfüllen.

Mit den bekannten Hochfrequenz-Ionenstrahlquellen ist es jedoch nicht möglich, die in der Praxis bestehenden Forderungen nach intensiven Strahlen veränderlicher Ionenenergie bis hinab zu extrem niedrigen Werten zu erfüllen und insbesondere auch Metallionen herzustellen.

Aufgabe der Erfindung ist es daher insbesondere, eine Hochfrequenz-Ionenstrahlquelle der eingangs angegebenen Art in der Weise auszubilden, daß bei weitestgehend monoenergetischer Energieverteilung der Ionen sowohl die Ionenenergie als auch die Ionenstromdichte kontinuierlich in einem großen Bereich äußerst feinfühlig verändert werden kann und vor allem auch intensive Metallionenstrahlen sehr niedriger Energie erzeugt werden können. Eine Strahldivergenz soll dabei vermieden bzw. zumindest weitestgehend vermieden werden.

Gelöst wird diese Aufgabe nach der Erfindung im wesentlichen dadurch, daß die eine selbsttätige Ringentladung bewirkende und zur Erzeugung eines nicht isothermen Plasmas aus Ionen, Elektronen und Neutralgasteilchen dienende HF-Spule koaxial im Inneren des Ionisatorgefäßes angeordnet ist, daß das Ionisatorgefäß als zumindest an den Oberflächen metallisch leitendes Gefäß ausgebildet ist, und daß das Strahlbildungssystem aus einer Kombination von Vielloch-Extraktionsgittern und einer sich daran unmittelbar anschließenden, insbesondere wahlweise zuschaltbaren Ionen-Fokussiereinheit besteht.

Durch die Anordnung der HF-Spule im Inneren des Ionisatorgefäßes und die Verwendung eines zumindest metallisch leitende Oberflächen aufweisenden Ionisatorgefäßes ergibt sich nicht nur eine hochfeste Anordnung von robustem und kostengünstigem Gesamtaufbau, sondern es wird vor allem auch möglich, Metallionen herzustellen, da dabei nicht mehr die bei bekannten Quarzgefäßen mit außenliegender HF-Spule bestehende Gefahr gegeben ist, daß sich die dissoziierten, leitfähigen Stoffe an der Innenwand des Quarzgefäßes niederschlagen, einen leitenden Belag erzeugen und dann die HF-Energie gegen das Eindringen in das Entladungsplasma abschirmen. Durch das erfindungsgemäße Strahlbildungssystem in Form einer Kombination von Vielloch-Extraktionsgittern und einer sich daran unmittelbar anschließenden, insbesondere wahlwei se zuschaltbaren Ionen-Fokussiereinheit, die auf ionenoptischer, elektrostatischer, magnetostatischer oder elektromagnetischer Basis arbeiten kann, wird erreicht, daß kontinuierlich einstellbare Ionenstromdichten in einem großen Bereich, insbesondere im Bereich von weniger als 1 mA/cm² bis mehr als 10 mA/cm² bei annähernd monoenergetischer und kontinuierlich veränderbarer Ionenenergie, insbesondere zwischen 3 keV und etwa 10 eV gewährleistet werden können, und zwar auch bei unabhängig einstellbaren und hohen Stromdichten. Die Hochfrequenz-Ionenstrahlquelle gemäß der Erfindung ist für eine breite Vielfalt von Ionen einschließlich Metallionen aus gasförmigen Metallverbindungen und Ionen reaktiver Gase verwendbar. Sie zeichnet sich durch lange Lebensdauer und lange Wartungsintervalle aus.

Das Ionisatorgefäß besteht bevorzugt aus chemisch resistentem, unmagnetischem Metall und kann mit einer Flüssigkeitskühlung, z.B. einer Wasserkühlung, versehen sein.

Die HF-Spule besteht vorzugsweise aus einer von Kühlflüssigkeit durchströmten Spule aus nichtmagnetischem, elektrisch gut leitfähigem Material, welche wegen der hohen Plasmaleitfähigkeit und der unterschiedlichen HF-Spannungen längs der Spule mit einer isolierenden schicht, z.B. in Form eines Quarzstrumpfes oder einer Glasauflage, überzogen ist.

Das Ionisatorgefäß ist an einem Ende mit einem Deckel und am anderen Ende mit einem Befestigungsflansch versehen. Über diesem Befestigungsflansch kann ein von außen erfolgendes Anflanschen der Ionenquelle an die zugehörige Vakuumkammer erfolgen, in der beispielsweise ein Druck von 10⁻⁴ bis 10⁻⁸ Torr herrscht.

Über den vorzugsweise einteilig mit dem Behälter ausgebildeten Deckel erfolgt zum einen der Gaseinlaß und zum anderen die Durchführung der Spulenanschlüsse, wobei zu diesem Zweck isolierte Spulendurchführungen mit innenseitig gelegener Schattenabschirmung verwendet sind, so daß sichergestellt ist, daß die Durchführungen gegen Metallniederschläge geschützt sind.

Am metallischen Außenmantel des Ionisatorgefäßes ist bezüglich Ionisatorgefäß und Spule mittig ein Ring von Permanentmagneten mit alternativer Polung zur Reduktion von Entladungsverlusten an der Wandung des Ionisatorgefäßes angebracht. Bei gegebener HF-Leistung lassen sich auf diese Weise Plasma- und Strahldichten steigern, da durch eine derartige "Cusp-Field-Anordnung" der Plasmaverluststrom auf die Ionisatorwand stark reduziert und bei geeigneter Anordnung dieser Permanentmagnete zudem das Plasma über den Extraktionsöffnungen konzentriert wird.

Die gemäß der Erfindung vorgesehenen Extraktionsgitter bilden bevorzugt ein Vielloch-Dreigitter-Extraktionssystem, dessen erste Gitterelektrode mit dem metallischen Ionisatorgefäß verbunden ist und bei dem die Dickenabmessungen der einzelnen gegeneinander isolierten Gitterelektroden und ihr gegenseitiger Abstand sehr klein und vorzugsweise deutlich kleiner als 1 mm sind, wobei zur Gewährleistung exakter Abstände der Gitterelektroden eine zentrale Mittenhalterung vorgesehen ist, welche auch die thermischen Durchbiegungen der Gitter begrenzt.

Die gemäß der Erfindung vorgesehene Ionen-Fokussiereinheit, welche vor allem bei niedrigen Ionenenergien und zugleich hohen Stromdichten zugeschaltet wird, besteht bevorzugt aus einer ionenoptischen Fokussierungslinse, die von der dritten Gitterelektrode und zwei Ringelektroden gebildet ist, welche bezüglich der Strahlachse unter einem spitzen Winkel, insbesondere einem Winkel von etwa 15° zurückversetzt sind.

Im Bereich des vorzugsweise geerdeten Quellenausgangs oder innerhalb der Ionenlinse kann gemäß einer Ausführungsvariante der Erfindung ein Glühwendeln aufweisender Strahlneutralisator vorgesehen sein, der vorteilhaft bei isolierenden oder zumindest eine isolierende Oberfläche aufweisenden Targets und ferner dazu einsetzbar ist, die Raumladungsverbreiterung des Ionenstrahls bei niedrigen Energien zusätzlich abzubauen.

Schließlich kann im Bereich des Quellenausgangs zur Unterstützung der Strahlbündelung eine magnetische Linse mit einer der Ionenenergie angepaßten Feldstärke vorgesehen sein.

Im Rahmen eines Verfahrens zum Betrieb der Ionenstrahlquelle nach der Erfindung ist es vorteilhafterweise möglich, daß die von der HF-Leistung und/oder der Extraktionsspannung abhängige Stromdichte und die Ionenenergie unabhängig voneinander verändert werden können. Dadurch gelingt es vor allem, die unterschiedlichsten und auch schwierigsten in der Praxis vorkommenden Aufgaben optimal zu lösen.

Diese Aufgaben lassen sich folgendermaßen erklären. Die Energien und Stromdichten der auf dem Substrat ankommenden Ionen müssen nämlich für die jeweils gewünschte Schichtqualität des vorgesehenen Materials ausgewählt und optimiert werden. Das hat die folgenden Gründe:

Oft ist zum Aufwachsen einer bestimmten Kristallorientierung eine sowohl minimale als auch maximale Auftreffenergie der Ionen erforderlich. Viele Kristalle sind beispielsweise endotherm aufgebaut, wobei ihr aufbau auch häufig von Energiezufuhr und Wärmeableitung richtungsabhängig ist. Auch ist die Kristallitform, wie sie in der Gestalt von runden Klumpen, langen Nadeln, Stengeln oder schieferförmig angeordneten Platten erscheinen kann, beim Aufwachsen von der Energie der auftreffenden Ionen und Atomen abhängig.

Weiterhin hat die auf dem Substrat auftreffende Ionenstrom-oder Atomstromdichte einen großen Einfluß auf das gesamte Kristallitgefüge und damit auch auf die Aufwachsrate der gesamten Schicht. Beide, die Ionenstromdichte und die Ionenenergie müssen individuell für jede Materialart und Schichtqualität optimiert werden, was die erfindungsgemäße Ionenstrahlquelle ermöglicht.

Bei der Grundlegung einer gut haftenden Grenzschicht zwischen dem Substrat und der eigentlichen Schicht wird of mit hohen Ionenenergien gearbeitet, um eine Art von Ionenimplantation und damit eine besondere Verankerung der beabsichtigten Schicht in der Unterlage (Substrat) zu erhalten. Die Ionenimplantation ergibt den Einbau von Atomen sowohl zwischen den Kristalliten als auch innerhalb (interstitial) der Kristallite bis zu einigen Atomnetzebenen tief in die Kristalle der Unterlage. Hierbei wird gleichzeitig ein Diffusionsaustausch der ankommenden Atome mit den kristalliteigenen Atomen ermöglicht. Diese führt beispielsweise zu Mischkristallen, festen Lösungen und intermetallischen Verbindungen.

All dies Erwähnte ermöglicht die erfindungsgemäße Ionenstrahlquelle in nacheinander kontinuierlichen Verfahrensschritten ohne Unterbrechung in derselben Vakuumanlage und an derselben Stelle anzuwenden. Somit können mehrere Verfahrensstufen wie Oberflächenreinigung mittels Kathodenzerstäubung durch Ionen hoher Energie, danach Aufbau einer gut haftenden Grenzschicht und schließlich der Aufbau der gewünschten schicht wie oben erwähnt, ohne Unterbrechung und mit derselben Ionenstrahlquelle durchgeführt werden.

Beispielsweise können die Verfahrensschritte durch Kombinationen aus wenigstens einigen der nachfolgenden Verfahrensschritte bestehen

a) die Substratoberfläche wird mit geeigneter Ionenenergie und Ionenstromstärke mittels Ionenätzung gereinigt und teilweise abgetragen,

b) die Substratoberfläche wird die Kratern und Furchen zum Zwecke der mechanischen Verankerung der vorgesehenen Schicht aufgerauht,

c) die Substratoberfläche wird mit einem Strahl von Ionen niedriger Energie und Stromdichte erwärmt und entgast,

d) in das Substrat werden bei optimierter Stromdichte Ionen mit höherer Engerie hineingeschossen (Ionenimplantation), so daß die Ionen einerseits bis einige Atomnetzebenen tief in die Kristallite, und zwar in die Zwischenräume der Kristallatome und andererseits zwischen den Kristalliten (inter grain) eindringen, und das Interdiffusion von Atomen angeregt wird, wobei insbesondere

e) der Einschuß von Ionen Mischkristallisierung, feste Lösungen und z.B. intermetallische Verbindungen der eintreffenden Ionen mit dem Material des Substrates und somit eine feste Verankerung der vorgesehenen Schicht an der Substratoberfläche bewirkt,

f) Schichten aus Metalle, Elemente oder Verbindungen werden auf die Substratoberfläche aufgebaut mit der für jedes Kristallitgefüge und jede Kristallitform erforderlichen optimalen Ionenenergie und optimalen Ionenstromdichte, und

g) Schichten aus Metalle, Elemente oder Verbindungen werden auf die Substratoberfläche aufgebaut mit der für jede Kristallstruktur und deren Textur und Kristallorientierung erforderlichen optimalen Ionenengerie und optimalen Ionenstromdichte.

Um diese Möglichkeit noch weiter zu erläutern können beispielsweise die oben erläuterten Verfahrensschritte a), c), d), e), f) und g) dazu verwendet werden, um Hartmetall oder Keramikschichten auf anorganischen Substraten anzubringen. Dagegen eignet sich eine Kombination der Schritte a), b), c), f), g) für die Anbringung von Metallschichten auf modernen Kunststoffen beispielsweise von Gold auf Polytetrafluorethylen. Das erfindungsgemäße Verfahren ist auch durchwegs geeignet für die Beschichtung von Halbleiter beispielsweise für die Anbringung von Kontakten auf Halbleitern auf Galliumarsenidbasis. Hierfür eignet sich eine Kombination der oben erwähnten Verfahrensschritte a), c), f), g).

Besonders wichtig ist auch, daß man mehrere Ionenquellen mit passenden Ionenstromdichten und Ionenenergien dafür verwenden kann um Legierungen und Verbindungen von beispielsweise auch komplexer Art herzustellen bzw. auf Substrate aufzubauen.

Es soll auch erwähnt werden, daß eine weitere magnetische Nachfokussierung im Verfahrensraum erfindungsgemäß vorgenommen werden kann, um die Neigung der Ionen, insbesondere bei niedrigen Ionenenergien zu divergieren, entgegenzuwirken. Das heißt, diese magnetische Nachfokussierung wird in der Verfahrenskammer zwischen der Ionenstrahlquelle und dem Substrat vorgenommen bzw. angeordnet.

Weitere vorteilhafte Merkmale und Ausgestaltungen der Erfindung sind in Unteransprüchen angegeben.

Die Erfindung wird nachfolgend unter Bezugnahme auf die Zeichnung näher erläutert; in der Zeichnung zeigt:

Fig. 1 eine schematische Darstellung einer zur Herstellung von Schichten auf Substraten und zur Materialoberflächenbearbeitung geeigneten Hochfrequenz-Ionenstrahlquelle nach der Erfindung,

Fig. 2 ein Diagramm typischer Werte von Entladungs-und Plasmadaten in ihrem radialen Verlauf in einer Hochfrequenz-Ionenstrahlquelle nach Fig. 1,

Fig. 3 eine schematische Darstellung zur Erläuterung der Bildung eines Ionenteilstrahls durch Extraktion mittels eines Dreigitter-Elektrodensystems aus dem Plasma einer Hochfrequenz-Ionenstrahlquelle nach Fig. 1,

Fig. 4 ein Diagramm des extrahierbaren Gemtionenstroms des Extraktionssystems nach Fig. 3,

Fig. 5 eine Schnittdarstellung einer praktischen Ausführungsform einer Hochfrequenz-Ionenstrahlquelle nach der Erfindung,

Fig. 6 eine Teildarstellung einer magnetischen Zusatzfokussierung zur Verwendung bei einer Ionenstrahlquelle nach Fig. 5 für sehr niedrige Ionenenergien,

Fig. 7 ein Diagramm typischer Entladungskennlinien einer Ionenstrahlquelle nach Fig. 5, und

Fig. 8 ein Diagramm der erforderlichen Extraktionsspannung des Gittersystems einer Ionenstrahlquelle nach Fig. 5 für Argon als Funktion der Stromdichte bzw. des extrahierten Ionenstroms.

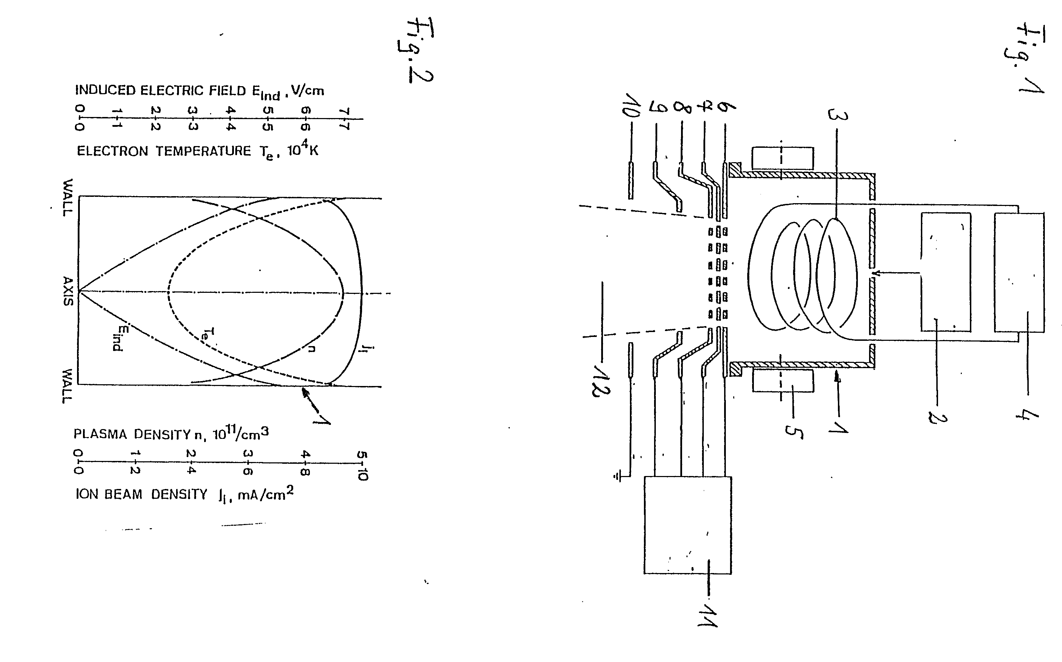

Nach Fig. 1 besteht eine Hochfrequenz-Ionenstrahlquelle aus einem metallischen Ionisatorgefäß 1 mit zugeordnetem Gasversorgungssystem 2, einer innerhalb des Ionisatorgefäßes 1 angeordneten HF-Spule 3 mit zugeordnetem Hochfrequenzgenerator 4 sowie einem Strahlbildungssystem, das aus drei Gitterelektroden 6, 7, 8 und zwei zu einer Ionenlinse gehörenden Ringelektrode 9, 10 besteht.

Die Gitterelektroden bzw. Ringelektroden sind mit Hochspannungsgeneratoren 11 verbunden. Das Ionisatorgefäß ist von Permanentmagneten in einer bestimmten Anordnung 5 umgeben.

In dem Ionisatorgefäß 1 werden die aus dem Gasversorgungssystem 2 einströmenden Arbeitsgase ionisiert, d.h. in positive Ionen und Elektronen zerlegt und damit ein Plasmazustand geschaffen.
Die für eine induktive, hochfrequente und selbständige Ringentladung erforderliche Entladungsleistung wird durch den Hochfrequenzgenerator, der vorzugsweise im Bereich von 0,5 bis 30 MHz arbeitet, erzeugt und über die Induktionsspule 3 eingekokkelt.
Dabei ensteht zunächst im Spuleninneren ein hochfrequentes, axiales Magnetfeld, dad durch Induktion ein elektrisches Wirbelfeld mit geschlossenen Feldlinien gleicher Frequenz erzeugt. In diesem Wirbelfeld werden Entladungselektronen auf annähernd kreisförmigen Bahnstücken solange beschleunigt, bis sie neue Ionisierungsakte ausführen können. Im Zusammenwirken von elastischen Zentralstößen mit Richtungsumkehr und dem Richtungswechsel des hochfrequenten, azimuthalen E-Feldes können die davon betroffenen Elektronen rasch Energie akkumulieren. Durch optimale Anpassung von Generatorfrequenz, Entladungsdruck und Ionisatorgefäßumfang wird dieser Akkumulierungsprozeß statistisch günstig beeinflußt. Auch die Ionisatorgefäßlänge kann in Abhängigkeit vom Gefäßradius und der Ionenmasse optimiert werden, um maximale Ionenausbeuten zu erhalten.

Da die ionisierenden Elektronen aus vorangegangenen Ionisierungsakten entstanden sind, liegt eine selbständige Gasentladung vor, die zur Speisung keine Glühkathoden benötigt. Hieraus ergeben sich die hohen Zuverlässigkeitsgrade und die langen Lebensdauern der HF-Entladungen, besonders auch beim Betrieb mit reaktiven Gasen.

Die Zündung der HF-Entladung erfolgt entweder bei ausreichend hohem Betriebsdruck selbsttätig durch einen Hochspannungsplus oder bei niedrigem Gasdruck durch einen kurzen, dosierten Druckstoß. Die Aufbauzeit der HF-Entladung beträgt nur rund 30 $\mu$s, was ein weiterer, für manche Anwendungen wichtiger Vorteil ist.
Die HF-Entladung erzeugt ein aus Ionen, Elektronen und Neutralgasteilchen aufgebautes, nicht isothermes Plasma.

Wie sich aus Fig. 2 ergibt, erreicht die Elektronentemperatur $T_e$ einige $10^4$ K, während Ionentemperatur und insbesondere Neutralteilchentemperatur nur wenig über Zimmertemperatur liegen. Dies vereinfacht auch die Kühlung des gesamten Ionisators.

Ein weiterer Vorteil der HF-Entladung ist die annähernd reine Maxwell-Verteilung der Plasmaelektronen, und dies bedeutet, daß quantitativ kaum Zweifachionen auftreten und somit die gewünschte Energiehomogenität nicht durch Teilchen doppelter bzw. mehrfacher Energie gestört wird.
Aufgrund des Induktionsgesetzes ist die elektrische Wirbelfeldstärke E auf der Ionisatorachse gleich Null und steigt zum Spulenradius hin an, und dieser Verlauf wird durch den Skineffekt noch verstärkt. Als Folge davon wächst auch die Elektronentemperatur $T_e$ nach außen hin stark an, wie dies Fig. 2 zeigt.

Die Plasmadichte n nimmt hingegen zum rand hin ab, und zwar infolge der Ladungsträgerbewegung mit anschließender Ionen-Elektronenrekombination.
Da die extrahierbare Strahlstromdichte proportional n $\sqrt{T_e}$ ist, heben sich hierbei beide Effekte annähernd auf, so daß die Hochfrequenz-Ionenstrahlquelle über das gewünscht homogene Strahlprofil verfügt. Da die Plasmadichte n und somit auch die extrahierbare Strahldichte linear mit der Leistung des HF-Generators wachsen, ist die erzielbare lonendichte nur durch das Extraktionssystem und durch die maximale Betriebstemperatur der mit einer Kühleinrichtung versehbaren lonenstrahlquelle begrenzt.

Das in Fig. 1 gezeigte System zur Bildung des lonenstrahls 12 hat die Aufgabe, die Plasmaionen aus dem Ionisator zu extrahieren, zu beschleunigen und zu dem Strahl 12 zu fokussieren.

Um diese Aufgaben auch für Strahlspannungen bzw. Ionenenergien weit unterhalb von 100 V lösen zu können, ist bei der erfindungsmäßen Hochfrequenz-Ionenstrahlquelle eine Kombination von Vielloch-Extraktionsgittern und einer ionenoptischen Fokussiereinheit vorgesehen.

Alle zu diesem in Fig. 1 schematisch gezeigten Strahlbildungssystem gehörenden Gitter- und Ringelektroden 6, 7, 8, 9, 10 bestehen vorzugsweise aus Molybdän, V2A-Stahl oder dergleichen, da für diese Elektroden geringe thermische Ausdehnungskoeffizienten und hohe Temperaturstabilität zu fordern ist. Die einzelnen Elektroden sind an entsprechende Hochspannungsquellen angeschlossen.

Die erste Gitterelektrode, die auch als Extraktionsanode zu bezeichnen ist, liegt auf einem positiven Potential von etwa 10 vis 3000 V. Sie ist mit dem im Betrieb als Anode wirkenden Ionisatorgefäß 1 elektrisch und thermisch leitend verbunden und legt zusammen mit der auf Massepotential festgehaltenen letzten Elektrode 10 die Strahlspannung bzw. Ionenenergie (ca. 10 bis 3000 eV) fest.

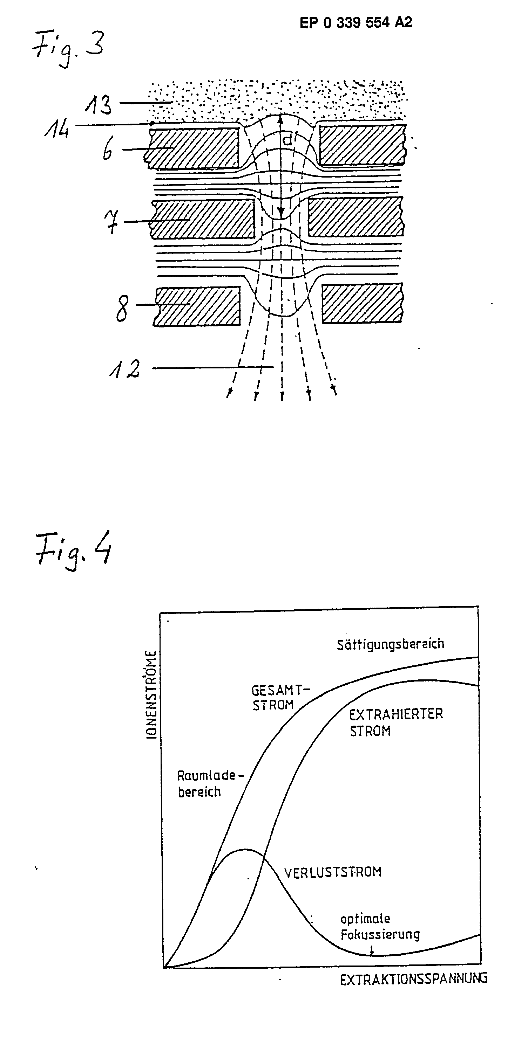

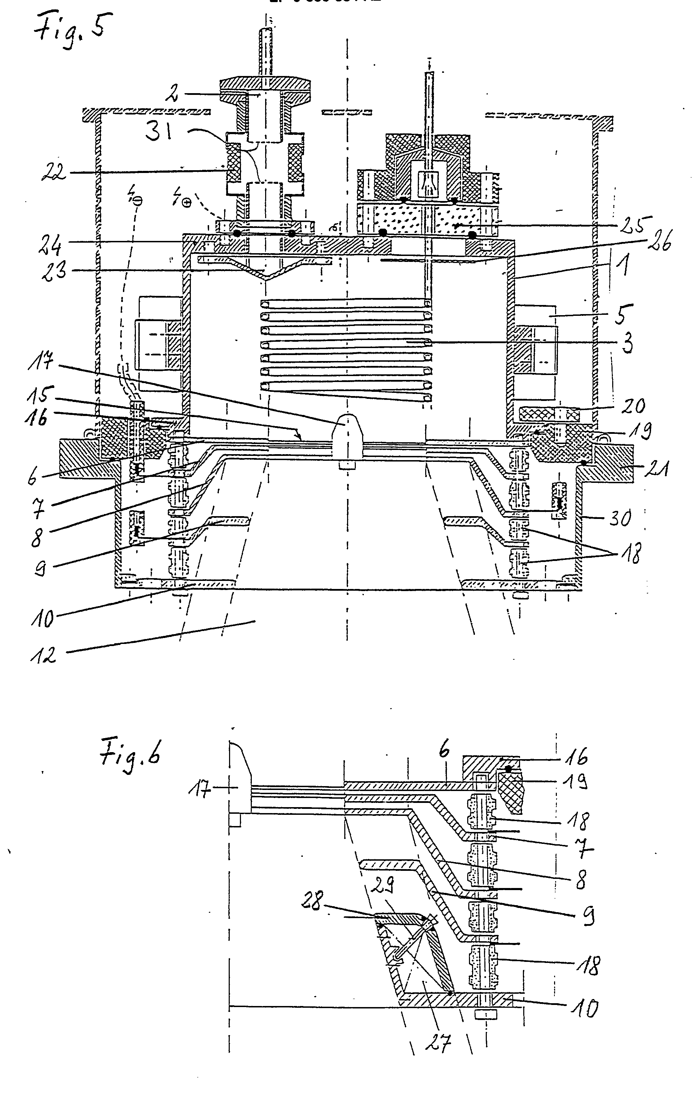

Die zweite Gitterelektrode 7, die als Extraktionskathode zu bezeichnen ist, ist gerade so hoch negativ vorgespannt, daß die Potentialdifferenz zur ersten Gitterelektrode 6 die von der optimalen Extraktionsspannung abhängige Stromdichte liefert. Der Abstand der in Fig. 3 angedeuteten Plasmagrenzfläche 14 von der zweiten Gitterelektrode 7 stellt hierbei unter Berücksichtigung des Durchgriffs die Beschleunigungsstreck d der Ionen dar (vgl. Fig. 3).

Die dritte Gitterelektrode 8, die als Bremselektrode zu bezeichnen ist, muß nicht geerdet sein. Sie stellt gleichzeitig die erste Elektrode der hinter die Extraktionsstrecke geschalteten Ionenlinse dar und besitzt ein frei wählbares Potential.

Die erste Ringelektrode 9 stellt die Mittelelektrode der Ionenlinse dar, und ihr Potential muß den gewünschten Werten von Strahlstrom und Strahlspannung optimal angepaßt werden.

Die zweite Ringelektrode 10 liegt auf Massepotential und schließt die Ionenlinse sowie das gesamte Strahlbildungssystem ab.

Fig. 3 veranschaulicht den Potentialverlauf und die Ionenbahnen für einen Teilstrahl (Einzellochanordnung) innerhalb der drei Gitterelektroden 6, 7, 8.

Die Plasmaionen werden vom Extraktionsfeld zwischen den ersten beiden Elektroden 6, 7 erfaßt und auf die Öffnungen der zweiten Gitterelektrode 7 (Extraktionskathode) hin beschleunigt, während die Plasmaelektronen zurückgehalten werden, so daß eine positive Raumladung im Extraktionsgebiet entsteht. Die Grenze zwischen dem neutralen Plasma der HF-Entladung und der positiven Raumladezone wird als Plasmagrenze 14 bezeichnet und wirkt als Ionenemitter oder "virtuelle Anode".

Wenn eine bestimmte Ionenenergie und zugleich eine definierte Stromdichte verlangt werden, so kann dies im wesentlichen stets durch Einstellung der beiden ersten Gitternpotentiale $U_+ = U$ und $U_+ - U_- = U_{ex}$ erreicht werden.
Gewöhnlich liegt die gewünschte Strahlspannung unter der erforderlichen, stromdichte-bedingten Extraktionsspannung. In diesem Falle wendet man die sogenannte Beschleunigungs-Bremstechnik an und bremst die Ionen zwischen der zweiten Gitterelektrode 7 und der dritten Gitterelektrode 8 auf den gewünschten U-Wert wieder ab. Der gesamte extrahierte Ionenstrom ergibt sich multiplikativ aus der Stromdichte im Einzelextraktionsloch, der Anzahl der Extraktionslöcher und der Querschnittsfläche jedes einzelnen Loches. Die Stromdichte auf dem zu bestrahlenden Substrat folgt dann aus der Stromstärke, bezogen auf den Strahlquerschnitt am Ort des Substrats. Um das Entladungsplasma im HF-Ionisator quasi-neutral zu halten, müssen diesem eine dem extrahierten Ionenstrom äquivalente Anzahl von Plasmaelektronen entzogen werden. Dies geschieht selbsttätig durch die als Extraktionsanode wirkende erste Gitterelektrode 6, die positiv vorgespannt ist, und vor allem durch das mit dieser verbundene, metallische Ionisatorgefäß 1. Hierzu nimmt das Entladungsplasma selbsttätig ein Potential an, das um ca. 10 V über demjenigen der Extraktionsanode b liegt.

Das Strahlbildungssystem hat nicht nur die Aufgabe, einen gewünschten Ionenstrom zu extrahieren und auf die Sollspannung zu beschleunigen, sondern auch zu einem Strahl möglichst geringer Divergenz zu fokussieren. In gewissen Grenzen findet bereits eine Fokussierung der einzelnen Teilstrahlen innerhalb der drei Gitterelektroden 6, 7, 8 statt, wie dies Fig. 3 zeigt.

Dies ist eine Folge davon, daß bei ausreichend hoher, von der Entladungsleistung abhängiger Extraktionsspannung sich die Plasmagrenze hohlspiegelartig nach oben wölbt, damit auch alle Äquipotentialflächen im oberen Teil der Beschleunigungsstrecke entsprechend gewölbt werden und somit eine ionenoptische Immersionslinse entsteht, die ein Einschnüren der Teilstrahlen bewirkt. Als Folge davon ist es möglich, die Bohrungen in der zweiten Gitterelektrode 7 zu verkleinern und so den Neutralgasverlust zu reduzieren, was eine Verbesserung der Gasökonomie der Ionenquelle ermöglicht.

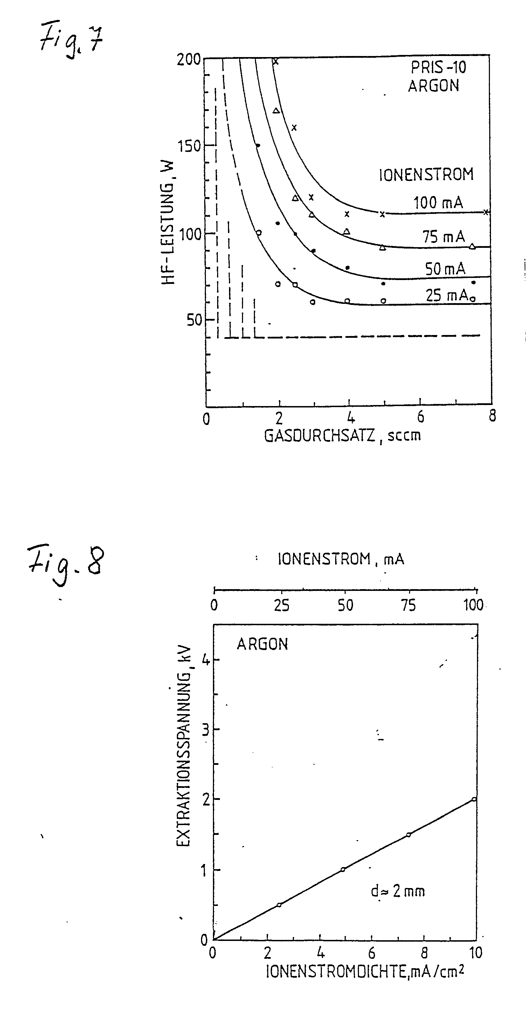

Die Diagrammdarstellung nach Fig. 4 zeigt den extrahierbaren Gesamtionenstrom eines Dreigitter-Extraktionssystems entsprechend Fig. 3, den Verluststrom auf die zweite Gitterelektrode 7 und den extrahierten Strom als Funktion der Extraktionsspannung.

Sind die Plasmadichte im Ionisator und die Extraktionsspannung genau aufeinander abgestimmt und liegt damit der sogenannte "optimal-fokussierte Fall" vor, so liegen die Brennflecke der Teilstrahlen genau in der Mitte der Bohrungen der zweiten Gitterelektrode 7. Der Verluststrom auf dieser die Extraktionskathode darstellenden Gitterelektrode 7 erreicht dabei ein Minimum. Ist die Extraktionsspannung zu groß oder zu klein, so liegt die Brennweite der Linse unter oder über dem Beschleunigungsabstand, wodurch der Verluststrom wächst und Leistungsverluste und Sputterschäden zunehmen.

Um die Forderungen nach sehr niedrigen Ionenenergien bei zugleich hohen Strahlstromdichten zu erfüllen und dabei gleichzeitig Strahlverbreiterungseffekte zu vermeiden, ist gemäß der Erfindung dem Gitterelektrodensystem eine Ionenfokussierungslinse nachgeschaltet, die aus der dritten Gitterelektrode 8 und zwei Ringelektroden 9, 10 besteht.

Fig. 5 zeigt eine Schnittdarstellung einer Ausführungsform einer Hochfrequenz-Ionenstrahlquelle nach der Erfindung. Das Ionisatorgefäß 1 besteht aus einem Metallzylinder von 10 cm Innendurchmesser und 6 cm lichter Höhe. Die Wandstärke des zylindrischen Teils beträgt 2 mm, und die Wandstärke des Deckels 24 beträgt 6 mm. Das Ionisatorgefäß 1 liegt auf einem positiven Strahlpotential im Bereich von + 10 V bis + 3000 V und kann mit einer Kühlung versehen sein.

In einem mit entsprechenden Ausfräsungen versehenen Messingring sind beispielsweise 16 Kobalt-Samarium-Permanentmagnete 5 angebracht, wobei der Magnetträgerring von oben über den Ionisatorzylinder geschoben und mit diesem verschraubt werden kann.

Die Gaszufuhr über einen Einlaß 2 erfolgt aus einem leicht auswechselbarem Vorratsbehälter mit Druckreduzierung und regelbarem Durchflußmesser über eine Kleinflanschverbindung und einem passenden, mit z.B. zwei Strahlnetzen 3' zur definierten Potentialtrennung versehenen Keramik-Isolator 22. Diese Gaszufuhr mündet im Ionisatorgefäß 1 in einem Gasverteilerkopf 23 mit ringförmigem Auslaßspalt.

Die wassergekühlte und mit einer isolierenden Schutzschicht überzogene HF-Spule 3 besteht beispielsweise aus einem 3 mm-Kupferrohr und besitzt beispielsweise 6 und 2/3 Windungen. Der Anschluß der HF-Spule 3 an den zugehörigen HF-Generator erfolgt durch den Ionisatordeckel 24 über zwei zum Zwecke der Verminderung von HF-Verlusten großflächige, vakuumgedichtete und durch Glimmerscheiben 26 gegen Metallniederschläge geschützte Durchführungen 25. Die beiden HF-Durchführungen 25 und die Gasdurchführung sind vorzugsweise auf dem Ionisatordeckel 24 dreiecksförmig angeordnet.

Das Strahlbildungssystem ist mit der ersten Gitterelektrode 6 direkt am Ionisatorgefäß 1 befestigt.

Das Dreigitter-Extraktionssystem 6, 7, 8 ist speziell für sehr niedrige Strahlspannungen ausgelegt. Über den gesamten Extraktionsquerschnitt 15 von beispielsweise 5,3 cm Durchmesser sind die beiden ersten Gitterelektroden 6, 7 nur je 0,5 mm dick und besitzen einen Abstand von ebenfalls nur 0,5 mm. Damit beträgt der strombestimmende, in Fig. 3 gezeigte Extraktionsabstand d nur ca. 2 mm.

Aus mechanischen und thermischen Gründen werden die Gitterelektroden 6, 7 außerhalb der Extraktionsfläche 15 auf je 1,5 mm verstärkt.

Wegen der hohen elektrischen und thermischen Leitfähigkeit, des geringen thermischen Ausdehnungskoeffizienten und der hohen thermischen Stabilität sowie der geringen Zerstäubungsrate werden alle Gitterelektroden bevorzugt aus Molybdän gefertigt.

Um die thermischen Durchbiegungen der Gitterelektroden zu limitieren, ist in Gittermitte eine räumlich kleine Stützvorrichtung bzw. Mittenhalterung 17 angebracht. Um die beiden ersten Gitterelektroden 6, 7 zusammen mit dieser Mittenhalterung 15 mechanisch stabil zu fixieren, is die dritte Gitterelektrode 8 über den gesamten Querschnitt hinweg relativ stabil und beispielsweise mit einer Dicke von etwa 2 mm ausgeführt, wobei die Extraktionsbohrungen vorzugsweise konisch angesenkt sind.

Bei der in Fig. 5 gezeigten Ausführungsvariante der Erfindung betragen die Einzellochdurchmesser der drei Gitterelektroden 6, 7, 8 jeweils 3 mm, 2 mm und 3,2 mm. Bei 5,3 cm Strahldurchmesser und einer Stegbreite der ersten Gitterelektrode 6 von 1 mm ergeben sich dabei 144 Extraktionsöffnungen, wobei zu bemerken ist, daß sich die Extraktionsfläche im Bedarfsfall auch weiter aufbohren läßt und ohne Schwierigkeiten etwa 300 Extraktionsöffnungen erreichbar sind.

Die dem Extraktionssystem nachgeschaltete ionenoptische Fokussierungslinse besteht zusätzlich zu dem dritten Extraktionsgitter 8 aus zwei unter einem Winkel von beispielsweise 15° gegen die Strahlachse zurückgesetzte, äquidistante V2A-Ringelektroden 9, 10.

Für das gesamte Strahlbildungssystem werden maximal vier Spannungsversorgungseinheiten benötigt, nämlich für die erste Gitterelektrode 6 einschließlich des Ionisatorgefäßes 1, die zweite Gitterelektrode 7, die dritte Gitterelektrode 8 und die erste Ringelektrode 9. Die die letzte Ionenlinsenelectrode bildende Ringelektrode 10 liegt auf Massepotential. Gegebenenfalls ist es auch möglich, zwei Elektroden direkt bzw. über einen Spannungsteiler an die gleiche Spannungsquelle anzuschließen.

Die fünf Electroden 6, 7, 8, 9, 10 werden durch vorzugsweise aus Macor bestehende Isolatoren 18 und Isolatorbolzen zentriert, welche in entsprechende Bohrungen des Ionisatorflansches 16 gesteckt sind. Über einen Tragering 19 aus Macor, Glasfaserpratzen 20 und die zweite Ringelektrode 10 ist das Ionisator- und Strahlbildungssystem am geerdeten Gehäuse 30 befestigt, das wiederum mit einem Flansch 21 versehen ist, mittels dessen ein von außen erfolgendes Anflanschen der Ionenquelle an die zugehörige Vakuumkammer möglich ist.

Fig. 6 zeigt eine Ausführungsvariante einer Hochfrequenz-Ionenstrahlquelle mit magnetischer Zusatzfokussierung für sehr niedrige Ionenenergie. Dazu ist ausgangsseitig eine Magnetfeldspule 27 vorgesehen, die eine magnetische Linse bildet, deren beispielsweise im Bereich von 10 bis 30 mT liegende Feldstärke der kinetischen Ionenenergie angepaßt werden kann. Die Magnetfeldspule 27 kann dabei zwischen der zweiten Ringelektrode 10 und einer Weicheisenabdeckung 28 angebracht sein, die mittels Schraubbolzen 29 an der Ringelektrode 10 befestigt ist.

Fig. 7 zeigt typische Entladungskennlinien einer Hochfrequenz-Ionenstrahlquelle nach Fig. 5 im Falle von Argon bei 2 MHz. Dabei ist der extrahierte Ionenstrom (als Parameter) in Abhängigkeit von Hochfrequenzleistung und Gasdurchsatz dargestellt.

Als waagerechte Grenzlinie für den Strom Null ergibt sich die HF-Wirbelstromverlustleistung der Ionenstromquelle von ca. 40 W, während die senkrechten Asymptoden durch die theoretisch 100 %ige Gasökonomie dargestellt werden. Bemerkenswert ist die sehr hohe Ionenausbeute (Strahldichte pro HF-Leistung), die im Vergleich zu herkömmlichen Geräten etwa doppelt so hoch ist.

Bei entsprechenden HF-Leistungen und Gasdurchsätzen lassen sich Gesamtionenströme von mehr als 200 mA problemlos herstellen.

Um einen bestimmten, vorgegebenen Ionenstrom zu extrahieren, müssen - wie dies Fig. 7 zeigt - HF-Leistung und Gasdurchsatz passend zueinander eingestellt werden, und außerdem muß - wie sich aus Fig. 8 ergibt - die notwendige Extraktionsspannung als Potentialdifferenz zwischen erster Gitterelektrode 6 und zweiter Gitterelektrode 7 angelegt werden. Unabhängig hiervon kann dann die Festlegung der Ionenenergie über das Potential der ersten Gitterelektrode 6 erfolgen.

Das Potential der zweiten Gitterelektrode 7 wird sodann als Differenz der erforderlichen, stromrelevanten Extraktionsspannung und der gewünschten Strahlspannung eingestellt, während die Ionenlinse bei niedrigen Ionenenergien und zugleich hohen Stromdichten hinzugeschaltet wird.

Der Fig. 8 ist ferner zu entnehmen, daß die erfindungsgemäße Ionenstrahlquelle mit geringen Extraktionsspannungen auskommt, die deutlich und insbesondere um den Faktor 2 bis 3,5 unter den Extraktionsspannungen herkömmlicher Ionenstrahlquellen liegen. So kann beispielsweise bereits mit 1 kV Extraktionsspannung eine Stromdichte von 5 mA/cm² erreicht werden, was besonders bei niedrigen Ionenenergien vorteilhaft ist, weil so das Beschleunigungs-Bremsverhältnis in Grenzen gehalten werden kann.

Die ionenoptische Strahllinse am Ausgang der Ionenstrahlquelle wirkt vor allem bei niedrigen Ionenenergien vorteilhaft auf die Stromverteilung, den Fokussierungsgrad und das Strahlprofil. Weiter verbessert werden kann die Qualität des Ionenstrahls durch eine ausgangsseitig vorgesehene Strahlneutralisation durch Elektronen, welche mittels Glühwendeln, die rund um den Strahl verteilt angeordnet sind, am geerdeten Quellenausgang erzeugt werden.

Von Vorteil ist auch, daß das negative Potential der Mittelelektrode der Ionenlinse das Dreigitter-Elektrodensystem gegen Neutralisatorelektronen abschirmt.

Die Hochfrequenz-Ionenstrahlquelle nach der Erfindung ist für eine breite Vielfalt von Ionen, einschließlich Metallionen aus gasförmigen Metallverbindungen und Ionen reaktiver Gase, z.B. $N^+$, $C^+$, $Si^+$, $B^+$, $Ti^+$, $Zr^+$ usw. verwendbar, ermöglicht kontinuierlich einstellbare Ionenstromdichten zwischen etwa 0,5 mA/cm² und 10 mA/cm² bei annähernd monoenergetischer und kontinuierlich veränderbarer Ionenenergie zwischen etwa 10 eV und etwa 3 keV auch bei unabhängig einstellbaren und hohen Stromdichten und liefert in dem hier beschriebenen Beispiel einen Strahldurchmesser von etwa 5 cm, so daß mit Substraten mit einem Durchmesser von größer als 5 cm gearbeitet werden kann, wobei der Abstand zwischen Ionenquelle und Substrat im Bereich von 20 cm bis 40 cm liegen kann. Ferner zeichnet sich die erfindungsgemäße Ionenstrahlquelle durch lange Lebensdauer und zeitlich lange Wartungsintervalle sowie vorteilhafte Handhabbarkeit aus, da sie problemlos von außen an die jeweils zugehörige Vakuumkammer, in der beispielsweise ein Druck von $10^{-3}$ bis $10^{-2}$ Pa herrschen kann, anflanschbar ist.

Durch Vergrößerung der Reaktorkammer und des Extraktionsgittersystems können auch wesentlich breitere Strahlen in verschiedenen Formen erzeugt werden. Bei geeigneter Geometrie des Extraktionssystems können die Strahlen entweder kreisrund oder oval oder sogar streifenförmig wie aus einem Schlitz austretend gebildet werden.

Auch die Divergenz des Strahles kann mittels geeigneter Ionenoptik und Extraktionsgittergeometrie beliebig gewählt werden.

## Ansprüche

1. Hochfrequenz-Ionenstrahlquelle, bestehend aus einem mit dem jeweils zu ionisierenden Arbeitsgas, insbesondere gasförmigen, kondensierbaren, metallischen Dämpfen und Metallverbindungen beschickbaren Ionisatorgefäß (1), einer mit einer Hochfrequenzquelle (4) verbundenen Spule (3) zur Erzeugung eines durch induktiv angeregte Entladung entstehenden Plasmas im Ionisatorgefäß (1), sowie einem Strahlbildungssystem mit mehreren Extraktionsgittern (6, 7, 8), dadurch **gekennzeichnet**, daß die eine selbsttätige Ringentladung bewirkende und zur Erzeugung eines nicht isothermen Plasmas aus Ionen, Elektronen und Neutralgasteilchen dienende HF-Spule (3) koaxial im Inneren des Ionisatorgefäßes (1) angeordnet ist, daß das Ionisatorgefäß (1) als zumindest an den Oberflächen metallisch leitendes Gefäß ausgebildet ist, und daß das Strahlbildungssytem aus einer Kombination von Vielloch-Extraktionsgittern (6, 7, 8) und einer sich daran unmittelbar anschließenden, insbesondere wahlweise zuschaltbaren Ionen-Fokussiereinheit (8, 9, 10) besteht.

2. Hochfrequenz-Ionenstrahlquelle nach Anspruch 1, dadurch **gekennzeichnet**, daß das Ionisatorgefäß (1) aus chemisch resistentem, unmagnetischem Metall besteht, auf positivem, insbesondere im Bereich von etwa + 10 V bis + 3000 V veränderbarem Strahlpotential liegt und mit einer Flüssigkeitskühlung versehen sein kann.

3. Hochfrequenz-Ionenstrahlquelle nach Anspruch 1, dadurch **gekennzeichnet**, daß die im Inneren des Ionisatorgefäßes (1) angeordnete, aus nicht magnetischem, elektrisch gut leitfähigem Material, insbesondere aus Kupfer oder Aluminium bestehende und von einem Kühlmedium durchströmte HF-Spule (3) mit einer isolierenden Schutzschicht überzogen ist, die vorzugsweise aus einem Quarzstrumpf, einer Gasauflage oder dergleichen besteht.

4. Hochfrequenz-Ionenstrahlquelle nach einem der vorhergehenden Ansprüche, dadurch **gekennzeichnet**, daß das Ionisatorgefäß (1) aus einem Metallzylinder mit einteilig ausgebildetem Deckel (24) und einem an dem vom Deckel (24) abgewandten Ende vorgesehenen Anschlußflansch (16) besteht, daß im Deckel (24) vorzugsweise gleichmäßig gegeneinander und zur Gefäßachse versetzt isolierte Spulendurchführungen (25) mit innenseitig gelegener Schattenabschirmung (26) und ein Gaseinlaß (2) mit einem innenseitig gelegenen Gasverteilerkopf (23) vorgesehen sind, und daß am Anschlußflansch (16) einerseits das Extraktionssystem (6, 7, 8, 9, 10) und andererseits über isolierende Zwischenglieder (19, 20) ein Befestigungsflansch (21) gehaltert ist, der ein von außen erfolgendes Anflanschen der Ionenquelle an die zugehörige Vakuumkammer ermöglicht.

5. Hochfrequenz-Ionenstrahlquelle nach einem der vorhergehenden Ansprüche, dadurch **gekennzeichnet**, daß am metallischen Außenmantel des Ionisatorgefäßes (1), ein insbesondere bezüglich dieses Ionisatorgefäßes (1) und der HF-Spule (3) mittig angeordneter Ring von Permanentmagneten (5) mit alternativer Polung zur Konzentration des Plasmas und zur Reduktion von Entladungsverlusten an der Wandung des Ionisatorgefäßes (1) angebracht ist.

6. Hochfrequenz-Ionenstrahlquelle nach einem der vorhergehenden Ansprüche, dadurch **gekennzeichnet**, daß die Extraktionsgitter (6, 7, 8) ein Vielloch-Dreigitter-Extraktionssystem bilden, dessen erste Gitterelektrode (6) mit dem metallischen Ionisatorgefäß (1) verbunden ist und bei dem die Dickenabmessungen der einzelnen gegeneinander isolierten Gitterelektroden (6, 7, 8) und ihr gegenseitiger Abstand kleiner als 1 mm sind und eine zentrale Mittenhalterung (17) zur Abstandsfixierung der Gitterelektroden (6, 7, 8) vorgesehen ist.

7. Hochfrequenz-Ionenstrahlquelle nach Anspruch 6, dadurch **gekennzeichnet**, daß die beiden ersten Gitterelektroden (6, 7) über den Extraktionsquerschnitt (15) eine Dicke von etwa 0,5 mm und kleiner und einen entsprechend geringen gegenseitigen Abstand besitzen, und daß die dritte Gitterelektrode (8) über ihren gesamten Querschnitt eine etwas größere Dicke aufweist und als Träger für die zentrale Mittenhalterung (17) dient.

8. Hochfrequenz-Ionenstrahlquelle nach Anspruch 7, dadurch **gekennzeichnet**, daß die Gitterelektroden (6, 7, 8) aus formstabilem und temperaturbeständigem Metall, z.b. aus Molybdän, V2A-Stahl oder dergleichen bestehen und daß die Durchmesser der insbesondere konisch angesenkten Extraktionsbohrungen in den aufeinanderfolgenden Gitterelektroden (6, 7, 8) unterschiedlich gewählt sind und insbesondere in Strahlrichtung gesehen etwa 3 mm, 2 mm und 3,2 mm betragen.

9. Hochfrequenz-Ionenstrahlquelle nach einem der vorhergehenden Ansprüche, dadurch **gekennzeichnet**, daß der Durchmesser der HF-Spule (3) zumindest im wesentlichen gleich dem Durchmesser der Extraktionsfläche (15) des Dreigitter-Extraktionssystems (6, 7, 8) ist.

10. Hochfrequenz-Ionenstrahlquelle nach einem der vorhergehenden Ansprüche, dadurch **gekennzeichnet**, daß die Ionen-Fokussiereinheit aus einer ionenoptischen Fokussierungslinse besteht, die von der dritten Gitterelectrode (8) und zwei Ringelektroden (9, 10) gebildet ist, welche bezüglich der Strahlachse unter einem spitzen Winkel, insbesondere einem Winkel von etwa 15°, zurückversetzt sind.

11. Hochfrequenz-Ionenstrahlquelle nach Anspruch 10, dadurch **gekennzeichnet**, daß die Gitter- und Ringelektroden (9, 10) formstabil und temperaturbeständig ausgebildet sind, aus V2A-Stahl, Molybdän oder dergleichen bestehen und zueinander zumindest im wesentlichen den gleichen Abstand besitzen wie die dritte Gitterelektrode (8) zur benachbarten Ringelektrode (9).

12. Hochfrequenz-Ionenstrahlquelle nach einem der vorhergehenden Ansprüche, dadurch **gekennzeichnet**, daß im Bereich des Quellenausgangs zur Unterstützung der Strahlbündelung eine magnetische Linse (27) mit einer der Ionenenergie angepaßten Feldstärke angeordnet ist.

13. Hochfrequenz-Ionenstrahlquelle nach einem der vorhergehenden Ansprüche, dadurch **gekennzeichnet**, daß im Bereich des vorzugsweise geerdeten Quellenausgangs oder innerhalb der Ionenlinse ein Glühwendeln umfassender Strahlneutralisator zum Einbringen von Elektronen in den Ionenstrahl (12) vorgesehen ist.

14. Hochfrequenz-Ionenstrahlquelle nach einem der vorhergehenden Ansprüche, dadurch **gekennzeichnet**, daß das Ionisatorgefäß (1) und/oder die Gitter- und Ringelektroden sowie die magnetische Linse (27) direkt oder indirekt unter Ausnutzung der Wärmeleitfähigkeit des jeweiligen Metalles durch ein Kühlmedium gekühlt sind.

15. Verfahren zum Betrieb einer Hochfrequenz-Ionenstrahlquelle nach einem oder mehreren der vorhergehenden Ansprüche, dadurch **gekennzeichnet**, daß die von der HF-Leistung und/oder der Extraktionsspannung abhängige Stromdichte und die Ionenenergie unabhängig voneinander veränderbar sind.

16. Verfahren nach Anspruch 15, dadurch **gekennzeichnet**, daß eine Zuschaltung der Ionenfokussierung vorgenommen wird, wenn die Ionenenergie den Wert von etwa 1000 eV und insbesondere den Wert von etwa 300 eV unterschreitet.

17. Verfahren nach den Ansprüchen 15 und 16, dadurch **gekennzeichnet**, daß bei geringen Ionenenergien, wenn sie den Wert von etwa 500 eV unterschreiten, eine Nachfokussierungsanordnung in Form von einem oder mehreren Magnetfeldspulen zwischen der vorhandenen Ionenoptik und dem empfangenden Substrat angeordnet ist.

18. Verfahren nach Anspruch 15 oder 16, dadurch **gekennzeichnet**, daß eine Raumladungskompensation mittels des Strahlneutralisators immer dann vorgenommen wird, wenn mit einem zumindest ein isolierende Oberfläche aufweisenden Substrat gearbeitet wird.

19. Verfahren nach einem der Ansprüche 16 bis 18, dadurch **gekennzeichnet**, daß bei Ionenenergien unterhalb von 500 eV eine Raumladungskompensation mittels des Strahlneutralisators vorgenommen wird.

20. Hochfrequenz-Ionenstrahlquelle nach einem der vorhergehenden Ansprüche, dadurch **gekennzeichnet**, daß oberhalb etwa 300 e.V. im Anschluß an das Extraktionssystem in vorgebbarem Abstand ein Nachbeschleunigungssystem angeordnet ist.

21. Anwendung des in den Ansprüchen 1 bis 20 beschriebenen Hf-Ionenstrahlquelle zur Herstellung gut haftender und besonderer Schichten mittels eines Verfahrens, das dadurch **gekennzeichnet** ist, daß in kontinuierlich ineinander übergehenden Verfahrensschritten die Ionenenergie, die Ionenstrahldichte und die Bestrahlungszeit in optimierter Weise verändert wird.

22. Die Anwendung der Hochfrequenzionenstrahlquelle gemäß Anspruch 21 derart, daß

a) die Substratoberfläche mit geeigneter Ionenenergie und Ionenstromstärke mittels Ionenätzung gereinigt und teilweise abgetragen wird,

b) die Substratoberfläche mit einem Strahl von Ionen niedriger Energie mit hoher Ionenstromdichte erwärmt und entgast wird,

c) die Substratoberfläche mit Kratern und Furchen zum Zwecke der mechanischen Verankerung der vorgesehenen Schicht bei geeigneter Ionenenergie und Ionenstromstärke aufgerauht wird,

d) die für jede einer Schicht eigenen Elastizität und thermischen Ausdehnungseigenschaft erforderliche duktile und elastische Anpassungsschicht durch geeignete Wahl der Ionenenergie und Ionenstromstärke gewährleistet ist,

10

e) die für jede Kristallstruktur und deren Orientierung erforderliche - oft sehr kritische - optimale Ionen energie und optimale Ionenstromdichte gewährleistet sind,

f) die für jede Kristallitgestalt und Kristallitgefüge erforderliche optimale Ionenenergie und Ionenstromdichte gewährleistet wird.

23. Die Anwendung der Hochfrequenzionenstrahlquelle gemäß Anspruch 21 derart, daß in das Beschichtungsverfahren ohne Unterbrechung des Verfahren in kontinuierlicher Weise eine besondere Verankerung mit verstärker Haftfestigkeit auf die folgende Weise hineingefügt wird:
Im Anschluß an die Reinigung und die Entgasung der Substratoberfläche gemäß den Merkmalen a) und b) des Anspruches 22 werden in das Substrat Ionen mit optimierter hoher Energie und optimierter Stromdichte hineingeschossen ("Ionenimplantation"), so daß diese Ionen einerseits bis einige Atomnetzebenen tief in die Kristallite, und zwar in die Zwischenräume der Kristallatome, und anderer seits zwischen den Kristalliten eindringen ("inter grain"), und daß Interdiffusion von Atomen angeregt wird, so daß feste Lösungen des eingeschossenen Atomsin den Kristalliten des Substratmaterials, Mischkristallisierung und auch beispielsweise bei Metallen intermetallische Verbindungen bewirkt werden.

24. Die Anwendung der Hochfrequenz-Ionenstrahlquelle gemäß der Ansprüche 21, 22 und 23 derart, daß mit mehreren Ionenquellen mit geeigneten Ionenenergien und Ionenstromdichte Legierungen und Verbindungen von beispielsweise auch komplexer Art hergestellt werden können.

Fig. 1

Fig. 2

Fig. 3

13

14

6

d

7

8

12

Fig. 4

IONENSTRÖME

Sättigungsbereich

GESAMT-
STROM

EXTRAHIERTER
STROM

Raumladebereich

VERLUSTSTROM

optimale
Fokussierung

EXTRAKTIONSSPANNUNG

Fig.5

Fig.6

Fig. 7

Fig. 8